# EUROPEAN PATENT SPECIFICATION

(11) **EP 1 168 439 B1**
(45) Date of publication and mention of the grant of the patent: **11.04.2007**
(21) Application number: 01250061.7
(22) Date of filing: 27.02.2001
(51) Int. Cl.: H01L 23/49

(54) **Gold bond wire for a semiconductor device**
Goldverbindungsdraht für ein Halbleiterbauelement
Fil de connexion en or pour un dispositif semi-conducteur

(30) Priority: 19.06.2000 JP 2000183521
(43) Date of publication of application: 02.01.2002
(73) Proprietor: TANAKA DENSHI KOGYO KABUSHIKI KAISHA, Chuo-ku, Tokyo (JP)
(72) Inventor: Ichimitsu, Itabashi, c/o Mitaka Factory, Mitaka-shi, Tokyo (JP); Shin, Takaura, c/o Mitaka Factory, Mitaka-shi, Tokyo (JP)
(74) Representative: Wablat, Wolfgang

(56) References cited:
- EP-A- 0 743 679
- EP-A- 0 822 264
- EP-A- 0 882 264
- PATENT ABSTRACTS OF JAPAN vol. 2000, no. 05, 14 September 2000 (2000-09-14) -& JP 2000 040710 A (SUMITOMO METAL MINING CO LTD), 8 February 2000 (2000-02-08)
- PATENT ABSTRACTS OF JAPAN vol. 1998, no. 09, 31 July 1998 (1998-07-31) -& JP 10 098063 A (TANAKA DENSHI KOGYO KK), 14 April 1998 (1998-04-14)

## Description

### BACKGROUND OF THE INVENTION

### 1. Field of the Invention

The present invention relates to a gold wire, for bonding a semiconductor element, which is used for electrical connection between electrodes of semiconductor elements and external leads and, more specifically, it relates to a gold wire, for bonding a semiconductor element, that can be satisfactorily used even for pressure bonding on the external lead side, accomplished by low pressure bonding, when necessary.

### 2. Description of the Related Art

In packaging of semiconductor devices, the interconnections or bonding between electrodes of semiconductor elements and external leads are currently formed by a wiring method based on the widely used "ball bonding" method using gold wire. This method usually involves formation of wiring by heat-pressing bonding or ultrasonic-assisted heat-pressing bonding as the means of pressure bonding onto the electrodes of semiconductor elements.

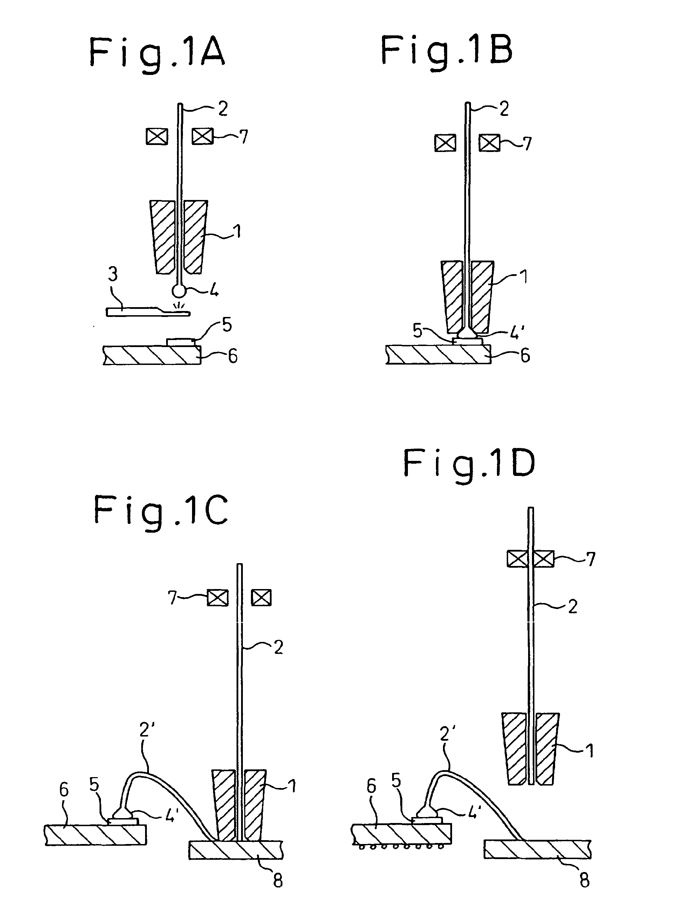

Figs. 1A-1D show ultrasonic-assisted heat-pressing bonding, for interconnection and loop formation, in which 1 is a capillary, 2 is a gold wire, 3 is a torch electrode, 4 is a metal ball, 5 is an Al electrode, 6 is a semiconductor element, 7 is a clamper and 8 is a lead.

In recent processes for manufacturing semiconductor devices, the ball neck portion is forcefully bent in the direction opposite to the loop formation direction during the loop forming process in order to stabilize the aforementioned loop shape to deform it, and then the final loop is actually formed, thus forming a loop by "reverse deformation". Many semiconductor devices are used under exposure to high temperature due to heating by operating circuits or external environments. It has therefore been sought to minimize wire breakage even after exposure to harsh heat-cycle environments after formation of loops by reverse deformation in this manner.

In Japanese Unexamined Patent Publication (Kokai) HEI No. 8-316262, Japanese Unexamined Patent Publication (Kokai) HEI No. 9-36162 and Japanese Unexamined Patent Publication (Kokai) HEI No. 11-214425, the present applicant has already disclosed that the aforementioned desired effects can be obtained by the use of gold wires with prescribed compositions as gold wires for loop formation.

Although these proposals have provided results in reducing wire breakage upon exposure to heat cycle environments, the gradually harsher environments of use appearing in recent years have led to demands for interconnections or bonding that can withstand wire breakage even when exposed to harsher heat cycle environments. In addition, increasing the amounts of elements added to prevent wire breakage in the aforementioned publications has been found to result in the drawback of greater electrical resistance. Furthermore, large loop heights must be maintained in the running of long loops and in high loops that have recently been employed as the number of pins increases.

In the second side junction in Figs. 1A-1D (hereunder also referred to as the lead 8 side junction), high pressure bonding can produce aberrations such as collapse of high loop shapes, and it is therefore desirable to use low pressure bonding. However, a low pressure bonding poses the problem of low junction strength. A desired goal for high loop wiring has therefore been to improve the junction strength even with a low pressure bonding at the second side junction, while maintaining the high loop shape. The present inventors have attempted to produce gold wires satisfying these properties, but the tensile strength has been insufficient.
The European patent application EP 0 822 264 describes a gold alloy wire for wedge bonding, which comprises 1 to 100 parts per million (ppm) by weight of Calcium (Ca), the remainder being gold and inavoidable impurities. The gold alloy wire has a gold purity of not less than 99.9%.
European patent application EP 0 743 679 describes a gold wire for IC chip bonding which wire is unlikely to be broken after thermosonic wire bonding at an increased ultrasonic output, subsequent reverse deformation involving severe bonding and deformation of a ball neck portion and formation of a loop. The gold wire must comprise from 0.0005 to 0.005 % (5-50 ppm) by weight of Mg and 0.0005 to 0.01% by weight (5-100 ppm) of Ge as the essential components, in addition to Pt, Ag and Eu.

It is an object of the present invention, which has been accomplished in light of these circumstances of the prior art, to provide a gold wire for ball-bonding a semiconductor element wherein the total amount of added elements is no greater than 100 ppm by mass in order to maintain low electrical resistance, which allows, firstly, reverse deformation in order to minimize wire breakage even upon exposure to harsh heat cycle environments after formation of the loop, which allows, secondly, formation of high loops at above a prescribed height, which allows, thirdly, maintenance of junction strength above a prescribed value even by a low pressure bonding at the second side junction in order to maintain the high loop shape, and which also allows, fourthly, maintenance of a high tensile strength.

### SUMMARY OF THE INVENTION

In order to achieve the aforementioned objects, the present invention provides a gold wire for semiconductor element ball-bonding which comprises 11-20 ppm by mass of Ag, 1-9 ppm by mass of Pt, 1-15 ppm by mass of Y, 1-15 ppm by mass of La, and 1-15 ppm by mass of Eu, with either or both 1-20 ppm by mass of Ca and 1-10 ppm by mass of Be, the total amount of the above elements being under 100 ppm by mass, the remainder being Au and unavoidable impurities. The purity of the gold of the gold wire before adding the above elements is at least 99.999%.

A method of wire ball-bonding of a semiconductor element with leads using the above gold wire is also provided. It is already known from the state of the art as described in the above-mentioned European patent application EP 0 743 679, to use 1-15 ppm by mass of Eu with either or both 1-20 ppm by mass of Ca and 1-10 ppm by mass of Be, whereas the total amount of the additive elements is not more than 100 ppm by mass. It is also known that the remainder are Au and unavoidable impurities, wherein the purity of the gold wire before adding the additive elements is at least 99.999%. However, it was unexpected that omitting Mg (and Ge) as additive element(s) would lead to high loops and a high junction strength even by low pressure bonding.

### BRIEF DESCRIPTION OF THE DRAWINGS

Figs. 1A to 1D are a set of illustrations showing a method for ultrasonic-assisted heat-pressing bonding between an electrode of a semiconductor element and an external lead using gold wire.

### EMBODIMENTS OF THE INVENTION

(1) Composition
   a) Starting gold
      The starting gold used is high purity gold which has been purified to at least 99.999 wt%. Higher purity gold is preferred because it can minimize the effects of harmful components.
   b) [Ag]
      The aforementioned objects can be achieved with an Ag content of 11-20 ppm by mass when the gold alloy wire used for the invention contains the prescribed amounts of Pt, Y, La, Eu and Ca or Be.
      This improves the breaking strength after heat cycle testing and allows a high tensile strength to be maintained unlike when the Ag content is less than 11 ppm by mass. It also drastically improves the second side peel strength upon low pressure bonding, while also allowing a high tensile strength to maintained unlike when the Ag content is greater than 20 ppm by mass. The Ag content is therefore limited to 11-20 ppm by mass when in the presence of the prescribed amounts of Pt, etc.
   c) [Pt]
      The aforementioned objects can be achieved with a Pt content of 1-9 ppm by mass when the alloy gold wire used for the invention contains the prescribed amounts of Ag, Y, La, Eu and, Ca or Be.
      This improves the breaking strength after heat cycle testing and allows a high tensile strength to be maintained unlike when the Pt content is less than 1 ppm by mass. It also drastically improves the second side peel strength upon low pressure bonding, while also allowing a high tensile strength to maintained unlike when the Pt content is greater than 9 ppm by mass. The Pt content is therefore limited to 1-9 ppm by mass when in the presence of the prescribed amounts of Ag, etc.
   d) [Y]
      The aforementioned objects can be achieved with a Y content of 1-15 ppm by mass when the alloy gold wire used for the invention contains the prescribed amounts of Ag, Pt, La, Eu and Ca or Be.
      This improves the breaking strength after heat cycle testing and allows a high tensile strength to be maintained unlike when the Y content is less than 1 ppm by mass. It also allows the loop height to be increased while also drastically improving the second side peel strength upon low pressure bonding, unlike when the Y content is greater than 15 ppm by mass.
      The Y content is therefore limited to 1-15 ppm by mass when in the presence of the prescribed amounts of Ag, etc.
   e) [La]
      The aforementioned objects can be achieved with an La content of 1-15 ppm by mass when the alloy gold wire used for the invention contains the prescribed amounts of Ag, Pt, Y, Eu and Ca or Be.
      This improves the breaking strength after heat cycle testing and allows a high tensile strength to be maintained unlike when the La content is less than 1 ppm by mass. It also allows the loop height to be increased while also drastically improving the second side peel strength upon low pressure bonding and allowing a high tensile strength to maintained, unlike when the La content is greater than 15 ppm by mass.
      The La content is therefore limited to 1-15 ppm by mass when in the presence of the prescribed amounts of Ag, etc.
   f) [Eu]
      The aforementioned object can be achieved with a Eu content of 1-15 ppm by mass when the alloy gold wire used for the invention contains the prescribed amounts of Ag, Pt, Y, La and Ca or Be.
      This improves the breaking strength after heat cycle testing and allows a high tensile strength to be maintained unlike when the Eu content is less than 1 ppm by mass. It also allows the loop height to be increased while also drastically improving the second side peel strength upon low pressure bonding and allowing a high tensile strength to maintained, unlike when the Eu content is greater than 15 ppm by mass.
      The Eu content is therefore limited to 1-15 ppm by mass when in the presence of the prescribed amounts of Ag, etc.
   g) [Ca, Be]
      The aforementioned object can be achieved with either or both a Ca content of 1-20 ppm by mass and a Be content of 1-10 ppm by mass when the alloy gold wire used for the invention contains the prescribed amounts of Ag, Pt, Y, La and Eu.
      This improves the breaking strength after heat cycle testing and allows a high tensile strength to be maintained unlike when both the Ca and Be contents are less than 1 ppm by mass. It also allows the loop height to be increased while also drastically improving the second side peel strength upon low pressure bonding and allowing a high tensile strength to be maintained, unlike when the Ca content is greater than 20 ppm by mass or the Be content is greater than 10 ppm by mass.
      Either or both the Ca content and the Be content are therefore limited to 1-20 ppm by mass and 1-10 ppm by mass, respectively, when in the presence of the prescribed amounts of Ag, etc.
(2) Gold wire fabrication process
   An example of a process for fabrication of a gold wire for a semiconductor element used for the invention will now be explained. After first melting the metal with the prescribed composition and casting it into an ingot, it is rolled using a groove-type rolling machine, and then with intermediate annealing, a fine wire of 10-100 µm diameter is made by final cold working, after which it is subjected to final annealing so as to have an elongation of 4-6% of the wire and the wire surface is coated with a lubricating rust preventing agent. The completely worked wire is then re-wound up onto a spool with a 50.3 mm outer diameter at a prescribed tension and to a prescribed length to prepare the final product. The prescribed lengths used are 100-3000 m, although even longer lengths are becoming common.
(3) Uses
   The gold wire of the invention is used for bonding between electrodes of a semiconductor element and external leads, and the bonding method is usually bonding and interconnecting according to the ball bonding method, such as shown in Fig. 1A-1D. This is preferably employed with a so-called "high loop" in which wire 2' is high as in Fig. 1D. A method of bonding by the ball bonding method will now be explained with reference to Figs. 1A to 1D.

As shown in Fig. 1A, the gold wire 2 is inserted through a capillary 1, and an electric torch 3 is situated opposite the tip end of the wire 2 and creates an electric-discharge reaching to the gold wire 2, thus heating the tip of the gold wire 2 and fusing it to form a ball 4.

Next, as shown in Fig. 1B, the capillary 1 is lowered for pressing bonding onto an Al electrode 5 on the semiconductor element 6. Here, ultrasonic vibrations (not shown) are passed through the capillary 1 and applied thereto while the semiconductor element 6 is heated with a heater block, so that the ball 4 is heat-pressing bonded, becoming a pressure bonded ball 4'.

Next, as shown in Fig. 1C, the capillary 1 is moved and lowered onto an external lead 8 following a prescribed trajectory. Ultrasonic vibrations (not shown) are passed through the capillary 1 and applied thereto while the external lead 8 is heated with a heater block, so that the surface of the gold wire 2 is heat-pressing bonded to the external lead 8.

Finally, as shown in Fig. 1D, the clamper 7 is raised while clamping the gold wire 2, thus cutting the gold wire 2 and completing the wiring. The wiring section is then sealed with a resin to complete the semiconductor device.

### Examples

### Example 1

After adding prescribed amounts of Ag, Pt, Y, La, Eu, Ca and Be to high purity gold with a purity of 99.999 wt% or greater and melting the mixture in a vacuum fusion furnace, it was cast to obtain a gold alloy ingot with the composition shown in Table 1; this was subjected to cold working with a groove roll and wire drawing machine and then intermediate annealing with the final cold working giving a diameter of 25 µm, and after final annealing to an elongation of 4% of the wire, the surface of the wire was coated with a lubricant and the gold alloy wire was finished.

### (Measuring methods)

(1) Wire breakage after heat cycle testing
   A test material was used as a bonding wire for ultrasonic heat-pressing bonding onto electrodes of an IC chip using a high-speed automatic bonder. After ball bonding with an ultrasonic output of 0.196 W and a load of 0.49 N, the capillary was first moved in the direction opposite to the loop formation direction, the reverse angle was set to an angle of 60° with respect to the vertical, the ball neck section was forcefully bent for deformation to form and maintain an inner warp, and this was then joined to an external lead to form a regular loop (wiring). A total of 200 pin wirings were formed for each IC chip. The wiring sample was sealed with a resin and then subjected 2000 times to a maximum harshness heat cycle test with a cycle of -55°C x 30 minutes and 160°C x 30 minutes. One hundred IC chips were prepared for testing, and the presence of wire breakage was determined by a conduction test. The number of ICs with wire breakage sections are shown in Table 1 as the breakage rate (%).
(2) Loop height
   The aforementioned heat cycle test was carried out in the same manner except that the wiring was formed without reverse deformation, and bondings were formed to a total of 8 IC chips. Two hundreds wires from arbitrarily selected ICs were then measured for loop height using a length measuring microscope. The average value is listed in Table 1 as the loop height.
(3) Second side peel strength with low output contact bonding

Low output contact bonding was carried out with an ultrasonic output of 0.157 W (commonly 0.235 W) and a load of 0.392 N (commonly 0.588 N) as the pressing bonding conditions for the second side (lead side) as shown in Fig. 1C. After wiring formation as shown in Fig. 1D, the center section of the wiring was cut, the tip of the lead side wire was grasped with tweezers supplied with the bond tester and the load required for the wire lifted up from the anchored lead to peel from the lead was measured. A total of 50 points were measured, and the average value is listed in Table 1 as the second side peel strength with low pressure bonding.

### Examples 2-17, Comparative Examples 1-12

Gold alloy wires were produced and tested in the same manner as Example 1, except that the amounts of the elements were changed as shown in Tables 1 and 2. The test results are also shown in Tables 1 and 2.

**Table 1**

| | Composition (mass ppm) | | | | | | | | | * Test results | | | |
|---|---|---|---|---|---|---|---|---|---|---|---|---|---|
| | Added elements | | | | | | | | Au & unavoidable impurities | Wire breakage after heat cycle test (%) | Loop height (µm) | Second side peel strength with low output contact bonding (mN) | Tensile strength (mN) |
| | Ag | Pt | Y | La | Eu | Ca | Be | Total | | | | | |
| Example 1 | 11 | 5 | 10 | 10 | 10 | 10 | 5 | 61 | remainder | 0 | 187 | 58 | 131 |
| 2 | 15 | 5 | 10 | 10 | 10 | 10 | 5 | 65 | remainder | 0 | 182 | 58 | 136 |
| 3 | 20 | 5 | 10 | 10 | 10 | 10 | 5 | 70 | remainder | 0 | 181 | 52 | 141 |
| 4 | 15 | 1 | 10 | 10 | 10 | 10 | 5 | 61 | remainder | 0 | 184 | 56 | 130 |
| 5 | 15 | 9 | 10 | 10 | 10 | 10 | 5 | 69 | remainder | 0 | 186 | 59 | 139 |
| 6 | 15 | 5 | 1 | 10 | 10 | 10 | 5 | 56 | remainder | 0 | 192 | 62 | 130 |
| 7 | 15 | 5 | 15 | 10 | 10 | 10 | 5 | 70 | remainder | 0 | 185 | 55 | 140 |
| 8 | 15 | 5 | 10 | 1 | 10 | 10 | 5 | 56 | remainder | 0 | 193 | 61 | 132 |
| 9 | 15 | 5 | 10 | 15 | 10 | 10 | 5 | 70 | remainder | 0 | 188 | 57 | 142 |
| 10 | 15 | 5 | 10 | 10 | 1 | 10 | 5 | 56 | remainder | 0 | 197 | 60 | 132 |
| 11 | 15 | 5 | 10 | 10 | 15 | 10 | 5 | 70 | remainder | 0 | 186 | 54 | 141 |
| 12 | 15 | 5 | 10 | 10 | 10 | 1 | 5 | 56 | remainder | 0 | 203 | 64 | 133 |
| 13 | 15 | 5 | 10 | 10 | 10 | 20 | 5 | 75 | remainder | 0 | 170 | 51 | 144 |
| 14 | 15 | 5 | 10 | 10 | 10 | 10 | 1 | 61 | remainder | 0 | 184 | 55 | 130 |
| 15 | 15 | 5 | 10 | 10 | 10 | 10 | 10 | 70 | remainder | 0 | 188 | 57 | 140 |
| 16 | 15 | 5 | 10 | 10 | 10 | 10 | - | 60 | remainder | 0 | 181 | 58 | 135 |
| 17 | 15 | 5 | 10 | 10 | 10 | - | 5 | 55 | remainder | 0 | 186 | 57 | 134 |

**Table 2**

| | Composition (mass ppm) | | | | | | | | | * Test results | | | |
|---|---|---|---|---|---|---|---|---|---|---|---|---|---|
| | Added elements | | | | | | | | Au & unavoidable impurities | Wire breakage after heat cycle test (%) | Loop height (µm) | Second side peel strength with low output contact bonding (mN) | Tensile strength (mN) |
| | Ag | Pt | Y | La | Eu | Ca | Be | Total | | | | | |
| Comp. Ex. 1 | - | 5 | 10 | 10 | 10 | 10 | 5 | 60 | remainder | 10 | 190 | 60 | 115 |
| 2 | 15 | - | 10 | 10 | 10 | 10 | 5 | 60 | remainder | 43 | 188 | 57 | 117 |
| 3 | 15 | 5 | - | 10 | 10 | 10 | 5 | 55 | remainder | 24 | 186 | 58 | 109 |
| 4 | 15 | 5 | 10 | - | 10 | 10 | 5 | 55 | remainder | 24 | 188 | 58 | 111 |
| 5 | 15 | 5 | 10 | 10 | - | 10 | 5 | 55 | remainder | 10 | 187 | 59 | 108 |
| 6 | 15 | 5 | 10 | 10 | 10 | - | - | 50 | remainder | 30 | 191 | 60 | 105 |
| 7 | 30 | 5 | 10 | 10 | 10 | 10 | 5 | 80 | remainder | 0 | 179 | 8 | 127 |
| 8 | 15 | 10 | 10 | 10 | 10 | 10 | 5 | 70 | remainder | 0 | 183 | 12 | 129 |
| 9 | 15 | 5 | 20 | 10 | 10 | 10 | 5 | 75 | remainder | 0 | 135 | 30 | 139 |
| 10 | 15 | 5 | 10 | 20 | 10 | 10 | 5 | 75 | remainder | 0 | 138 | 33 | 145 |
| 11 | 15 | 5 | 10 | 10 | 20 | 10 | 5 | 75 | remainder | 0 | 141 | 28 | 146 |
| 12 | 15 | 5 | 10 | 10 | 10 | 30 | 5 | 85 | remainder | 0 | 130 | 19 | 149 |
| 13 | 15 | 5 | 10 | 10 | - | 30 | 5 | 75 | remainder | 0 | 131 | 20 | 140 |

### (Test results)

(1) All of the Examples 1 to 17 in which the amounts of each of the elements Ag, Pt, Y, La, Eu, Ca and Be were within the ranges of the invention were excellent products exhibiting 0% wire breakage after the heat cycle test under the harsh conditions used, while having high loop heights of 170 µm or greater, peel strengths of 51 mN or greater even with low pressure bonding on the second side (lead side), and being capable of maintaining a high tensile strength of 130 mN or greater.
   The construction of the present invention therefore achieves the object of the invention which is to provide a gold wire for semiconductor element bonding wherein the total amount of the added elements is no greater than 100 ppm by mass and which allows, firstly, reverse deformation in order to minimize wire breakage even upon exposure to harsh heat cycle environments after formation of loops, which allows, secondly, formation of high loops at above a prescribed height, which allows, thirdly, maintenance of junction strength above a prescribed value even with a low pressure bonding at the second side junction in order to maintain the high loop shape, and which allows, fourthly, maintenance of a high tensile strength.
(2) For Comparative Examples 1 to 5, one of the elements of Ag, Pt, Y, La and Eu were not added in the composition of 15 ppm by mass of Ag, 5 ppm by mass of Pt, 10 ppm by mass of Y, 10 ppm by mass of La, 10 ppm by mass of Eu, 10 ppm by mass of Ca and 5 ppm by mass of Be, while for Comparative Example 6, Ag, Pt, Y, La and Eu were added but without Ca and Be; all of these samples had unacceptable wire breakage of 10-43% after the heat cycle test under the harsh conditions used, and despite a high loop height and improved second side peel strength with low pressure bonding, the tensile strength was insufficient at 105-117 mN, and therefore the samples of the invention were highly superior for achieving the object of the invention.
(3) For Comparative Examples 7 and 8, the Ag amount was increased above 20 ppm by mass or the Pt amount was increased above 9 ppm by mass in the composition of 15 ppm by mass of Ag, 5 ppm by mass of Pt, 10 ppm by mass of Y, 10 ppm by mass of La, 10 ppm by mass of Eu, 10 ppm by mass of Ca and 5 ppm by mass of Be; both of these samples allowed a high loop height, but the second side peel strength with low pressure bonding was 8-12 mN and the tensile strength was 127-129 mN, and therefore the samples of the invention were highly superior for achieving the object of the invention.
(4) For Comparative Examples 9 to 12, the Y amount was increased above 15 ppm by mass, the La amount was increased above 15 ppm by mass, the Eu amount was increased above 15 ppm by mass or the Ca amount was increased above 20 ppm by mass in the composition of 15 ppm by mass of Ag, 5 ppm by mass of Pt, 10 ppm by mass of Y, 10 ppm by mass of La, 10 ppm by mass of Eu, 10 ppm by mass of Ca and 5 ppm by mass of Be; all of these samples had loop heights of 130-141 µm and the second side peel strengths with low pressure bonding were 19-33 mN, and therefore the samples of the invention were highly superior for achieving the object of the invention.
(5) Comparative Example 13 which contained 15 ppm by mass of Ag, 5 ppm by mass of Pt, 10 ppm by mass of Y, 10 ppm by mass of La, 30 ppm by mass of Ca and 5 ppm by mass of Be in a composition containing no Eu, had a loop height of 131 µm and a second side peel strength with low pressure bonding of 20 mN, and therefore the samples of the invention were highly superior for achieving the object of the invention.

## Claims

1. A gold wire for ball-bonding a semiconductor element, which comprises 11-20 ppm by mass of Ag, 1-9 ppm by mass of Pt, 1-15 ppm by mass of Y, 1-15 ppm by mass of La, and 1-15 ppm by mass of Eu, with either or both 1-20 ppm by mass of Ca and 1-10 ppm by mass of Be, the total amount of the above additive elements being not more than 100 ppm by mass, the remainder being Au and unavoidable impurities, wherein the purity of the gold of the gold wire before adding the above elements is at least 99.999%.

2. Use of a gold wire in ball-bonding a semiconductor element, wherein the gold wire comprises 11-20 ppm by mass of Ag, 1-9 ppm by mass of Pt, 1-15 ppm by mass of Y, 1-15 ppm by mass of La, and 1-15 ppm by mass of Eu, with either or both 1-20 ppm by mass of Ca and 1-10 ppm by mass of Be, the total amount of the above additive elements being not more than 100 ppm by mass, the remainder being Au and unavoidable impurities, wherein the purity of the gold of the gold wire before adding the above elements is at least 99.999%.

## Patentansprüche

1. Goldverbindungsdraht zum Nagelkopfbonden eines Halbleiterelements, der 11-20 ppm Ag, 1-9 ppm Pt, 1-15 ppm Y, 1-15 ppm La und 1-15 ppm Eu sowie entweder 1-20 ppm Ca und/oder 1-10 ppm Be aufweist, wobei die Gesamtmenge der genannten Zusatzelemente nicht größer als 100 ppm ist und sich die Restmenge aus Au und unvermeidlichen Unreinheiten zusammensetzt, wobei die Goldreinheit des Goldverbindungsdrahtes vor dem Zusatz der genannten Elemente mindestens 99,999 % beträgt.

2. Verwendung eines Goldverbindungsdrahtes zum Nagelkopfbonden eines Halbleiterelements, **dadurch gekennzeichnet, dass** der Goldverbindungsdraht 11-20 ppm Ag, 1-9 ppm Pt, 1-15 ppm Y, 1-15 ppm La und 1-15 ppm Eu sowie entweder 1-20 ppm Ca und/oder 1-10 ppm Be aufweist, wobei die Gesamtmenge der genannten Zusatzelemente nicht größer als 100 ppm ist und sich die Restmenge aus Au und unvermeidlichen Unreinheiten zusammensetzt, wobei die Goldreinheit des Goldverbindungsdrahtes vor dem Zusatz der genannten Elemente mindestens 99,999 % beträgt.

## Revendications

1. Fil d'or pour la soudure d'un élément semi-conducteur par le procédé de soudure par écrasement de boule, qui comprend 11 à 20 ppm en masse de Ag, 1 à 9 ppm en masse de Pt, 1 à 15 ppm en masse de Y, 1 à 15 ppm en masse de La, et 1 à 15 ppm en masse de Eu, avec soit 1 à 20 ppm en masse de Ca, soit 1 à 10 ppm en masse de Be, soit les deux, la quantité totale des éléments additifs ci-dessus ne dépassant pas 100 ppm en masse, le reste étant Au et des impuretés inévitables, dans lequel la pureté de l'or du fil d'or avant addition des éléments ci-dessus est d'au moins 99, 999 %.

2. Utilisation d'un fil d'or pour la soudure d'un élément semi-conducteur par le procédé de soudure par écrasement de boule, dans lequel le fil d'or comprend 11 à 20 ppm en masse de Ag, 1 à 9 ppm en masse de Pt, 1 à 15 ppm en masse de Y, 1 à 15 ppm en masse de La, et 1 à 15 ppm en masse de Eu, avec soit 1 à 20 ppm en masse de Ca, soit 1 à 10 ppm en masse de Be, soit les deux, la quantité totale des éléments additifs ci-dessus ne dépassant pas 100 ppm en masse, le reste étant Au et des impuretés inévitables, dans lequel la pureté de l'or du fil d'or avant addition des éléments ci-dessus est d'au moins 99, 999 %.
